Europäisches Patentamt

European Patent Office

Office européen des brevets

(11) Numéro de publication: **0 241 416 B1**

# (12) FASCICULE DE BREVET EUROPEEN

(45) Date de publication de fascicule du brevet:
**29.01.92**

(51) Int. Cl.⁵: **G01R 31/08**, G01R 31/02

(21) Numéro de dépôt: **87810173.2**

(22) Date de dépôt: **25.03.87**

(54) **Procédé de localisation d'un défaut sur au moins un conducteur d'un câble électrique et dispositif pour la mise en oeuvre de ce procédé.**

(30) Priorité: **25.03.86 CH 1186/86**

(43) Date de publication de la demande:
**14.10.87 Bulletin 87/42**

(45) Mention de la délivrance du brevet:
**29.01.92 Bulletin 92/05**

(84) Etats contractants désignés:
**AT BE CH DE ES FR GB GR IT LI LU NL SE**

(56) Documents cités:
EP-A- 0 003 433     EP-A- 0 068 767
EP-A- 0 160 441     GB-A- 1 572 154
US-A- 3 800 216     US-A- 3 812 420

HEWLETT PACKARD JOURNAL, vol. 25, no. 4,
décembre 1973, pages 9-14, Palo Alto, US;
T.R. GRAHAM et al.: "Telecommunication cable fault location from the test desk"

(73) Titulaire: **Lavanchy, Gérard**
**Rue de Cossonay 39b**
**F-1008 Prilly(FR)**

(72) Inventeur: **Lavanchy, Gérard**
**Rue de Cossonay 39b**
**F-1008 Prilly(FR)**

(74) Mandataire: **Nithardt, Roland**
**Cabinet Roland Nithardt Conseils en Pro-**
**priété Industrielle S.A. Y-Parc Scientifique et**
**Technologique Chemin de la Sallaz Case**
**postale 3347**
**CH-1400 Yverdon-les-Bains(CH)**

Rank Xerox (UK) Business Services

## Description

La présente invention concerne un procédé de localisation d'un défaut sur au moins un conducteur d'un câble électrique comportant au moins deux conducteurs, ces conducteurs étant connectés en pont diviseur alimenté par une source de tension et raccordés à un circuit de mesure comportant un convertisseur analogique-numérique avec affichage, un organe de raccordement pourvu d'au moins trois broches pour connecter les conducteurs du câble un dispositif et un amplificateur d'entrée à gain variable monté en serie à l'entrée du convertisseur analogique-numerique.

Cette invention concerne également un dispositif convenant la mise en oeuvre de ce procédé de localisation d'un défaut sur au moins un conducteur d'une câble électrique comportant au moins deux conducteurs, ces conducteurs étant connectés en pont diviseur, ce dispositif comprenant une source de tension pour alimenter ce pont diviseur, un convertisseur analogique-numérique avec affichage et un organe de raccordement pourvu d'au moins trois broches pour connecter les conducteurs du câble au dispositif, un amplificateur d'entrée à gain variable étant monté en serie à l'entrée du convertisseur analogique-numérique.

Les aléas liés à la fabrication des câbles électriques multiconducteurs, de même que ceux liés à leur utilisation dans des installations ou à leur pose dans le terrain ont pour corollaires des défauts tels que fils cassés ou en court-circuit.

Tant le fabricant que l'utilisateur sont donc contraints à devoir rechercher l'emplacement de ces défauts afin de procéder à leur élimination. Les plus anciennes méthodes connues faisaient appel à l'utilisation de ponts de mesure potentionmétriques fonctionnant soit en courant alternatif à fréquence sonore, soit en courant continu. Relativement précis, ces ponts ont toutefois l'inconvénient d'une mise en oeuvre délicate et nécessitent des calculs de la part de l'opérateur.

Ces méthodes bien connues sont décrites entre autres dans A.C. Timms "The location of faults in lines and cables" et portent les noms de Wheatstone, Murray et Varley.

Divers perfectionnements ont été successivement proposés, parmi lesquels on citera l'emploi d'amplificateurs pour augmenter la sensibilité de l'intrument de détection, tels que par exemple ceux décrits par les brevets US-A-3'812'420 ou DE-A-3'032'777.

D'autres auteurs ont proposé dans le cas de ponts de résistance d'exprimer le résultat en unité de longueur. Le brevet US-A-3'812'420 permet, par un réglage approprié, de faire correspondre l'échelle de lecture du potentiomètre de mesure à une longueur plutôt qu'à une proportion, ledit potentiomètre étant décrit comme comportant deux curseurs. La publication EP-A-0 003 433 utilise une source de courant calibrée et suppose connue la résistance linéique du fil en mesure. Il en est de même de l'appareillage 4913 A de Hewlett Packard. L'inconvénient majeur de ces appareils réside dans l'approximation implicite faite sur la valeur de la résistance linéique dont la valeur réelle peut différer de quelques pour-cent de la valeur nominale. Il s'ensuit une erreur proportionnelle sur la mesure de la longueur. Il en est de même de l'erreur introduite par le coefficient de température de la résistivité, la température des conducteurs étant difficilement connue avec précision.

Enfin, une solution plus récente a été proposée par la publication EP-A-0 068 767 mais elle nécessite un microprocesseur pour effectuer la conversion numérique proportion-longueur, la longueur totale du circuit à mesurer étant introduite numériquement au moyen d'un clavier.

On ne citera que pour mémoire les systèmes complexes d'analyse de réseau, tels celui décrit dans la publication française FR-A-2'430'621 dont le but est tout autre et dont le fonctionnement n'est pas celui d'un pont.

Le but de la présente invention consiste en un procédé et un dispositif pour sa mise en oeuvre réunissant les avantages de faible coût, haute précision et facilité d'utilisation par lecture directe de la distance à laquelle se situe le défaut, pour permettre de localiser un défaut se présentant soit sous la forme d'un court-circuit, soit sous la forme d'un fil cassé, c'est-à-dire de définir la distance à laquelle se situe le défaut par rapport à l'une des extrémités, la longueur du câble étant seule connue.

Le procédé s'applique à tout câble comportant au moins deux conducteurs si les deux extrémités sont directement accessibles, au moins trois conducteurs si une seule extrémité est directement accessible, la seconde devant toutefois être mise en court-circuit, respectivement déconnectée des autres parties éventuelles d'un réseau.

Le procédé selon l'invention est caractérisé en ce qu'au cours d'une première phase, on connecte directement ledit circuit de mesure à la source de tension ou indirectement en le connectant aux bornes de l'une des résistances du diviseur de référence constitué de deux résistances identiques et en ce que l'on ajuste manuellement le gain de l'amplificateur d'entrée à gain variable, de manière à faire correspondre la valeur lue à l'affichage à la longueur connue du câble, et en ce qu'au cours d'une seconde phase, on connecte ledit circuit d'entrée à gain variable au pont diviseur constitué par les conducteurs en mesure, et en ce qu'on lit sur le convertisseur à affichage la distance à laquelle se situe le défaut à localiser, l'affichage de la longuer connu (L) du câble étant toutefois remplacé par l'affichage de la demi-longuer ($\frac{L}{2}$) pour la localisation d'un court-circuit dans le cas où l'on mesure un câble ne comportant que deux conducteurs.

Le dispositif selon l'invention est caractérisé en ce qu'il comporte un commutateur agencé pour connecter l'amplificateur d'entrée à gain variable soit directement à la source de tension, ou indirectement en le connectant aux bornes de l'une des resistances du diviseur de référence constitué de deux resistances identiques, afin d'ajuster manuellement le gain de l'amplificateur, soit au pont diviseur constitué par les conducteurs en mesure permettant ainsi l'affichage de la distance à laquelle se situe le défaut directement lue sur le même affichage que lors du calibrage.

Selon une première forme de réalisation la source de tension, le convertisseur analogique-numérique à affichage et le circuit d'entrée à gain variable sont du type à courant continu. Selon une deuxième forme de réalisation la source de tension, le convertisseur analogique-numérique à affichage et l'amplificateur d'entrée à gain variable sont du type à courant alternatif à très basse fréquence.

Selon une forme de réalisation préférée, l'amplificateur d'entrée à gain variable peut également comporter un amplificateur d'entrée monté entre le commutateur et l'amplificateur à gain variable, ledit amplificateur d'entrée étant à impédance d'entrée très élevée.

La source de tension alternative est avantageusement un générateur de tension à très basse fréquence.

Selon une forme de réalisation particulièrement avantageuse le dispositif selon l'invention comporte un circuit de compensation des capacités parasites comprenant de préférence un potentiomètre agencé pour reprendre une partie de la tension de la source de tension, un amplificateur associé à deux résistances qui définissent le gain de l'amplificateur, un potentiomètre agencé pour reprendre une partie de la tension de mesure et un condensateur connecté entre la sortie de l'amplificateur de compensation et une borne du pont diviseur, ce circuit étant ajusté pour compenser le courant capacitif parasite.

La présente invention sera mieux comprise en référence à la description d'exemples de réalisation et au dessin annexé dans lequel :

La fig. 1 est à titre d'exemple un schéma fonctionnel simplifié dans le cas de la localisation d'un court-circuit entre deux conducteurs d'un câble comportant au moins trois conducteurs.

La fig. 2 est à titre d'exemple un schéma fonctionnel simplifié dans le cas de la localisation de la coupure d'un conducteur.

La fig. 3 représente une vue partielle du circuit et montre comment l'effet des capacités parasites est compensé.

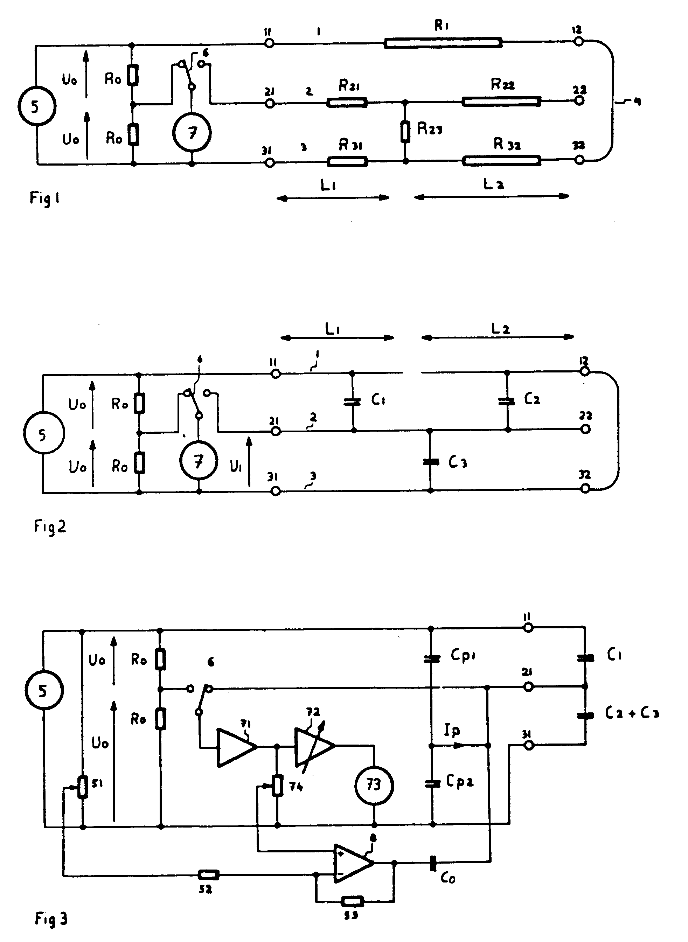

Selon la fig. 1, on considère les trois conducteurs, 1, 2 et 3 d'un câble de longueur L1 + L2, dont les conducteurs 2 et 3 présentent un court-circuit ou une conduction transverse accidentelle R23 à la distance L1 par rapport à l'extrémité définie par les points de connexion 11, 21, et 31.

Les conducteurs étant supposés présenter une résistance linéique constante et identique de l'un à l'autre, on peut écrire : R1 = R31 + R32 et en appliquant la loi d'Ohm :

$$\frac{L1}{L1+L2} = \frac{R31}{R31+R32}$$

Au cours d'une première phase du procédé, un générateur de tension 5 est connecté à un diviseur de référence constitué de deux résistances identiques R0 ainsi qu'aux extrémités 11 du conducteur 1 et 31 du conducteur 3. Un pontage de résistance négligeable 4 est effectué de l'autre extrémité 12 du conducteur 1 à l'extrémité 32 du conducteur 3. Un convertisseur analogique-numérique avec affichage 7, de préférence du type voltmètre numérique précédé d'un amplificateur d'entrée à gain variable, par exemple muni d'un diviseur résistif, est connecté aux bornes de l'une des résistances R0 du diviseur par le commutateur 6.

Dans une autre forme de réalisation, l'amplificateur d'entrée du convertisseur analogique-numérique 7 est directement connecté au générateur 5, le gain étant simultanément réduit de moitié et le diviseur supprimé.

Au cours de cette première phase du procédé, on ajuste manuellement le gain de l'amplificateur d'entrée pour que la valeur lue à l'affichage du convertisseur corresponde à la longueur L du câble en mesure, sans égard au fait que l'unité de longueur utilisée soit le mètre, le pied ou le yard. Au cours d'une seconde phase du procédé, on bascule le commutateur 6 pour connecter l'instrument entre les extrémités 21 et 31 du câble. La tension à ses bornes sera ramenée au coefficient

$$\frac{R31}{R31+R32} = \frac{L1}{L}$$

par rapport a sa valeur initiale L.

Il indiquera ainsi directement la valeur L1 recherchée, soit la distance à laquelle se trouve le défaut.

Le convertisseur analogique-numérique 7 est à impédance d'entrée élevée, de l'ordre du Gohm. La résistance R21 est donc sans influence sur la mesure. De même pour la résistance transverse R23, ce qui est particulièrement apprécié lorsque le défaut n'est pas franc, et dû à une entrée d'eau dans le câble, par exemple. Si le câble ne comporte que les deux conducteurs 2 et 3, le générateur est branché aux bornes 31 et 32 du conducteur 3, ce qui revient à remplacer le conducteur 1 de résistance R1 par un court-circuit.

Il est évident que dans ce cas le gain de l'amplificateur d'entrée du convertisseur analogique-numérique est alors ajusté pour que l'affichage initial corresponde à la demi-longueur ($\frac{L}{2}$) du câble.

Dans le cas d'un conducteur coupé, on voit à la fig. 2 que le même principe du diviseur de tension est encore appliqué, le générateur étant toutefois du type alternatif à très basse fréquence, de même que le convertisseur analogique-numérique.

On a ainsi

$$\frac{C1}{L1} = \frac{C2}{L2} \text{ avec } C1 + C2 = C3$$

si l'on admet que la construction du câble est symétrique, C1, C2, C3 étant les capacités partielles réparties du circuit considéré.

Dans le cas d'un câble téléphonique en paires, le conducteur 2 serait remplacé par la mise en parallèle du deuxième conducteur de deux paires ou des deux conducteurs de la deuxième paire s'il s'agit d'une construction en quartes.

Comme dans le cas de la localisation d'un court-circuit, le procédé consiste à ajuster manuellement le gain de l'amplificateur d'entrée pour faire correspondre à la tension Uo prélevée aux bornes de $R_0$ un affichage égal à la longueur du câble.

Le commutateur 6 est ensuite basculé en position de localisation. L'instrument mesure alors la tension aux bornes de C3, soit :

$$U1 = 2\,Uo \times \frac{\dfrac{1}{\omega\,(C2+C3)}}{\dfrac{1}{\omega\,(C2+C3)} + \dfrac{1}{\omega\,C1}} = 2\,Uo \times \frac{C1}{C1 + C2 + C3}$$

$$U1 = Uo\,\frac{C1}{C1 + C2} = Uo\,\frac{L1}{L1 + L2}$$

où $\omega = 2\pi F$ F étant la fréquence du signal issu du générateur.

Puisque par réglage initial on a fait correspondre Uo à la longueur du câble, soit L1 + L2, l'instrument indique ainsi directement L1.

Afin de ne pas être gêné par l'effet de la résistance des conducteurs lors de la mesure de câbles de grande longueur, plusieurs kilomètres par exemple, le générateur 5 est à très basse fréquence, par exemple 5 Hz ou même moins. De plus, le convertisseur analogique-numérique à sensibilité variable 7 comportera de préférence un redresseur synchrone qui ne prendra pas en compte la perditance du câble.

De tels circuits étant de conception classique, tel par exemple celui décrit dans le brevet CH-A-542 447, il n'en sera pas fait plus ample description.

On remarquera que le circuit schématique représenté à la fig. 1 ne précise pas si le générateur et le convertisseur analogique-numérique sont à courant alternatif ou à courant continu. Les deux solutions sont utilisables si l'on admet que la fréquence utilisée est très basse. Toutefois, une forme préférée de réalisation prévoit d'utiliser un générateur à courant continu, l'intensité du courant à fournir pour alimenter le circuit étant d'une part plus facile à obtenir sous cette forme et d'autre part, la valeur de la résistance de défaut R23 étant sans influence sur la précision de la mesure, ce qui n'est pas le cas en courant alternatif, la capacité des tronçons de conducteurs symbolisés par R21 et R31 étant en shunt du convertisseur analogique-numérique dont on a vu qu'il devait être à très haute impédance d'entrée.

En conséquence, la réalisation prévoit l'utilisation d'un générateur de tension commutable de courant alternatif à courant continu, la même commutation s'effectuant simultanément au circuit de mesure, soit amplificateur et voltmètre numérique, de préférence par le redresseur synchrone.

En référence à la figure 3, le convertisseur anlogique-numérique 7 de la fig. 2 est représenté de manière plus détaillée, et décomposé en ses constituantes, à savoir un préamplificateur à gain unité 71, suivi d'un amplificateur à gain variable 72, puis enfin du voltmètre numérique proprement dit 73.

Il a été dit plus haut que l'amplificateur 72 associé à l'instrument numérique de mesure 73 est à gain variable. Dans une forme préférée de réalisation, ce gain est ajusté manuellement au moyen de deux potentiomètres associés à l'amplificateur 72, dont l'un permet le réglage grossier, et l'autre le réglage fin. Le rapport extrême des gains utiles de cet amplificateur n'est que peu supérieur à 10, le passage d'une décade à l'autre, par exemple 0,124 km à 12,400 km, consistant simplement à déplacer le point décimal sur l'affichage, ce que permet l'utilisation de tout modèle du commerce.

L'expérience comme l'analyse du circuit indiquent que les capacités parasites inhérentes à la réalisation du circuit de mesure peuvent être figurées par deux condensateurs Cp1 et Cp2 en parallèle avec le diviseur C1, C2, C3 constitué par le câble en mesure.

Une fraction de la tension de sortie de l'amplificateur 71 est prélevée par le potentiomètre ajustable 74, de même qu'une fraction de la tension du générateur 5 est prélevée au moyen du potentiomètre 51. Ces tensions sont introduites aux entrées d'un amplificateur de type différentiel 8 dont le gain est défini par les résistances 52 et 53 et dont la sortie est reliée par un condensateur de compensation C0 à la borne 21 du pont diviseur.

Le calcul montre facilement que le courant Ip issu de ces capacités parasites comporte deux termes, dont l'un est fixe, compensable par le potentiomètre 51, et l'autre fonction du rapport $C1/(C2 + C3)$ compensable à partir d'une fraction de la tension de mesure issue du préamplificateur 71.

Les potentiomètres sont ajustés successivement en remplaçant le câble à mesurer par des condensateurs de valeur connue, par exemple $C1 = C2 + C3$ pour régler le potentiomètre 74, ce qui correspond à poser $L2 = 0$ et $C1 = 0$ pour régler le potentiomètre 51 correspondant à $L1 = 0$.

Ce réglage s'effectue en principe une fois pour toutes et ne doit être répété que si l'on modifie le système de connexion du câble celui-ci étant de préférence une pince telle que décrite dans le brevet CH-A-508 287 et dont le câble de raccordement est blindé. Ce blindage sera avantageusement relié à la sortie de l'amplificateur de compensation 8, la capacité entre blindage et conducteurs de la pince faisant partie intégrante de C0.

Il est à remarquer que le préamplificateur 71 est à impédance d'entrée très élevée comme dit plus haut à propos de la mesure en courant continu. Il n'influence donc pas le diviseur C1, C2, C3.

## Revendications

1. Procédé de localisation d'un défaut sur au moins un conducteur d'un câble électrique comportant au moins deux conducteurs (1,2,3), ces conducteur (1,2,3) étant connectés en pont diviseur alimenté par une source de tension (5) et raccordés à un circuit de mesure comportant un convertisseur analogique-numérique (7,73) avec affichage, un organe de raccordement pourvu d'au moins trois broches pour connecter les conducteurs du câble au dispositif et un amplificateur d'entrée à gain variable (72) monté en série à l'entrée du convertisseur analogique-numérique (7,73), caractérisé en ce qu'au cours d'une première phase, on connecte directement ledit circuit de mesure à la source de tension (5), ou indirectement en le connectant aux bornes de l'une des resistances ($R_0$) du diviseur de référence constitué de deux résistances identiques ($R_0$), et en ce que l'on ajuste manuellement le gain de l'amplificateur d'entrée à gain variable (72), de manière à faire correspondre la valeur lue à l'affichage à la longueur connue (L) du câble, et en ce qu'au cours d'une seconde phase, on connecte ledit amplificateur d'entrée à gain variable (72) au pont diviseur constitué par les conducteurs (1,2,3) en mesure, et en ce qu'on lit sur le convertisseur (7,73) à affichage la distance à laquelle se situe le défaut à localiser, l'affichage de la longueur connue (L) du câble étant toutefois remplacé par l'affichage de la demi-longueur $(\frac{L}{2})$ pour du localisation d'un court-circuit dans le cas où l'on mesure un câble ne comportant que deux conducteurs.

2. Procédé selon la revendication 1, caractérisé en ce que l'on utilise une source de tension (5), un convertisseur analogique-numérique avec affichage (7,73) et un amplificateur d'entrée à gain variable (72) du type à courant continu.

3. Procédé selon la revendication 1, caractérisé en ce que l'on utilise une source de tension (5), un convertisseur analogique-numérique (7,73) un amplificateur d'entrée à gain variable (72) du type à courant alternatif à très basse fréquence.

4. Dispositif convenant à la mise en oeuvre du procédé selon la revendication 1, pour la localisation d'un défaut sur au moins un conducteur d'un câble électrique comportant au moins deux conducteurs (1,2,3), ces conducteurs étant connectés en pont diviseur, ce dispositif comprenant une source de tension (5) pour alimenter ce pont diviseur, un convertisseur analogique-numérique (7,73) avec affichage et un organe de raccordement pourvu d'au moins trois broches pour connecter les conducteurs du câble au dispositif, un amplificateur d'entrée à gain variable (32) étant monté en série à l'entrée du convertisseur analogique-numérique, caractérisé en ce qu'il comporte un commutateur (6) agencé pour connecter l'amplificateur d'entrée à gain variable soit directement à la source de tension (5), ou indirectement en le connectant aux bornes de l'une des résistances ($R_0$) du diviseur de référence constitué de deux résistances identiques ($R_0$), afin d'ajuster manuellement le gain de l'amplificateur, soit au pont diviseur constitué par les conducteurs en mesure permettant ainsi l'affichage de la distance à laquelle se situe le défaut directement lue sur le même affichage que lors du calibrage.

5. Dispositif selon la revendication 4, caractérisé en ce que la source de tension (5), le convertisseur analogique-numérique (7,73) à affichage et l'amplificateur d'entrée à gain variable (72) sont du type à courant continu.

6. Dispositif selon la revendication 4, caractérisé en ce que la source de tension (5), le convertisseur analogique-numérique à affichage (7,73) et l'amplificateur d'entrée à gain variable (72) sont du type à courant alternatif à très basse fréquence.

7. Dispositif selon les revendications 5 ou 6, caractérisé en ce que l'amplificateur d'entrée à gain variable comporte également un amplificateur d'entrée (71) monté entre le commutateur (6) et l'amplificateur (72) à gain variable, et en ce que ledit amplificateur d'entrée (71) est à impédance d'entrée très élevée.

8. Dispositif selon la revendication 6, caractérisé en ce que la source de tension alternative est un générateur de tension à très basse fréquence.

9. Dispositif selon la revendication 6, caractérisé en ce qu'il comporte un circuit de compensation des capacités parasites comprenant un potentiomètre (51) agencé pour reprendre une partie de la tension de la source de tension (5), un amplificateur (8) associé à deux résistances (52, 53) qui définissent le gain de l'amplificateur (8), un potentiomètre (74) agencé pour reprendre une partie de la tension de mesure et un condensateur (C0) connecté entre la sortie de l'amplificateur de compensation et la borne (21) du pont diviseur, ce circuit étant ajusté pour compenser le courant capacitif parasite (Ip).

## Claims

1. A process for the localisation of a fault on at least one conductor of an electric cable comprising at least two conductors (1, 2, 3), with these conductors (1, 2, 3) being connected as a divider bridge supplied by a voltage source (5) and connected to a measurement circuit comprising an analog-numeric converter (7, 73) with display, a connecting element provided with at least three pins to connect the conductors of the cable to the device and a variable gain input amplifier (72) connected in series at the input to the analog-numeric converter (7, 73),

**characterised in that** during a first phase the said measurement circuit is connected directly to the

6

EP 0 241 416 B1

voltage source (5), or indirectly by connecting it to the terminals of one of the resistances (RO) of the reference divider formed by two identical resistances (RO),

**and in that** the gain of the variable gain input amplifier (72) is adjusted manually so as to make the value read from the display correspond to the known length (L) of the cable,

**and in that** during a second phase said variable gain input amplifier (72) is connected to the divider bridge formed by the conductors (1, 2, 3) being measured,

**and in that** from the display converter (7, 73) is read the distance at which the fault to be located is situated, with the display of the known length (L) of the cable still being replaced by the display of half the length (L/2) for the localisation of a short circuit in the case where a cable only having two conductors is measured.

2. A process according to Claim 1,
**characterised in that** a voltage source (5), an analog-numeric converter with display (7, 73) and a variable gain input amplifier (72) of the direct current type are used.

3. A process according to Claim 1,
**characterised in that** a voltage source (5), an analog-numeric converter (7, 73) and a variable gain input amplifier (72) of the very low frequency alternating current type are used.

4. A device suitable for the performance of the process according to Claim 1, for the localisation of a fault on at least one conductor of an electric cable comprising at least two conductors (1, 2, 3), with these conductors being connected as a divider bridge, with this device comprising a voltage source (5) to supply this divider bridge, an analog-numeric convertor (7, 73) with display and a connecting element provided with at least three pins to connect the conductors of the cable to the device, a variable gain input amplifier (32) being connected in series to the input of the analog-numeric converter,
**characterised in that** it comprises a commutator (6) designed to connect the variable gain input amplifier either directly to the voltage source (5), or indirectly by connecting it to the terminals of one of the resistances (RO) of the reference divider formed by two identical resistances (RO), so as to adjust the amplification gain manually, or to the divider bridge formed by the measurement conductors, thus permitting the display of the distance at which the fault directly read from the same display as during calibration is situated.

5. A device according to Claim 4,
**characterised in that** the voltage source (5), the analog-numeric converter (7, 73) with display and the variable gain input amplifier (72) are of the direct current type.

6. A device according to claim 4,
**characterised in that** the voltage source (5), the analog-numeric converter with display (7, 73) and the variable gain input amplifier (72) are of the very low frequency alternating current type.

7. A device according to Claim 5 or 6,
**characterised in that** the variable gain input amplifier also comprises an input amplifier (71) mounted between the commutator (6) and the variable gain amplifier (72),
**and in that** said input amplifier (71) has a very high input impedance.

8. A device according to Claim 6,
**characterised in that** the alternating voltage source is a very low frequency voltage generator.

9. A device according to Claim 6,
**characterised in that** it comprises a circuit for compensating parasite capacities comprising a potentiometer (51) designed to recapture a part of the voltage of the voltage source (5), an amplifier (8) connected to two resistances (52, 53) which define the gain of the amplifier (8), a potentiometer (74) designed to recapture a part of the measurement voltage and a condenser (C0) connected between the output of the compensating amplifier and the terminal (21) of the divider bridge, with this circuit being adjusted to compensate the parasite capacitive current (1p).

**Patentansprüche**

7

EP 0 241 416 B1

**1.** Verfahren zur Fehlerortbestimmung an mindestens einem Leiter eines elektrischen Kabels mit mindestens zwei Leitern (1,2,3), wobei diese Leiter (1,2,3) in Art einer von einer Spannungsquelle (5) versorgten Teilerbrücke verbunden und an eine Meßschaltung angeschlossen sind, die einen analognumerischen Wandler (7,73) mit Anzeige aufweist, sowie ein, mit mindestens drei Kontaktklemmen versehenes Anschlußelement, um die Leiter des Kabels an die Anordnung anzuschließen und einen in Serie am Eingang des analog-numerischen Wandlers (7,73) geschalteten Eingangsverstärkers mit variabler Leistung (72),
**dadurch gekennzeichnet,** daß
man im Verlauf einer ersten Phase die Meßschaltung direkt an die Spannungsquelle (5) anschließt oder indirekt, indem man sie mit den Klemmen eines der Widerstände ($R_0$) des aus zwei identischen Widerständen ($R_0$) bestehenden Bezugspunktteilers verbindet, und daß man von Hand die Verstärkung des Eingangsverstärkers (72) mit variabler Leistung einstellt, um den an der Anzeige abgelesenen Wert mit der bekannten Kabellange (L) in Übereinstimmung zu bringen, und daß man im Verlauf einer zweiten Phase den Eingangsverstärker mit variabler Leistung (72) mit der Teilerbrücke, die aus den zu messenden Leitern (1,2,3) besteht, verbindet, und daß man auf dem Wandler (7,73) mit Anzeige die Entfernung abliest, in der sich der zu lokalisierende Fehler befindet, wobei man indessen, im Falle, wo man ein nicht mehr als zwei Leiter aufweisendes Kabel mißt, für die Lokalisierung eines Kurzschlusses die Anzeige der bekannten Länge (L) des Kabels durch die Anzeige der halben Länge (L/2) ersetzt.

**2.** Verfahren ach Anspruch 1,
**dadurch gekennzeichnet,** daß
man eine Spannungsquelle (5), einen analog-numerischen Wandler mit Anzeige (7,73) und einen Eingangsverstärker mit variabler Leistung (72) für Gleichstrom verwendet.

**3.** Verfahren nach Anspruch 1,
**dadurch gekennzeichnet,** daß
man eine Spannungsquelle (5), einen analog-numerischen Wandler (7,73) und einen Eingangsverstärker mit variabler Leistung (72) für Wechselstrom mit sehr niedriger Frequenz verwendet.

**4.** Anordnung, geeignet für die Anwendung des erfindungsgemäßen Verfahrens nach Anspruch 1, zur Fehlerortbestimmung an mindestens einem Leiter eines elektrischen Kabels mit mindestens zwei Leitern (1,2,3), wobei diese Leiter in Art einer Teilerbrücke verbunden sind, und diese Anordnung eine Spannungsquelle (5) aufweist, um diese Teilerbrücke zu versorgen, desweiteren einen analognumerischen Wandler (7,73) mit Anzeige und ein mit mindestens drei Kontaktklemmen versehenes Anschlußelement, um die Leiter des Kabels mit der Anordnung zu verbinden, einen Eingangsverstärker mit variabler Leistung (72) der in Serie am Eingang des analog-numerischen Wandlers geschaltet ist,
**dadurch gekennzeichnet,** daß
sie einen Schalter (6) aufweist, der dazu dient, den Eingangsverstärker mit variabler Leistung entweder direkt mit der Spannungsquelle (5) zu verbinden oder indirekt, indem man ihn mit den Klemmen eines der Widerstände ($R_0$) des aus zwei identischen Widerständen ($R_0$) bestehenden Vergleichsteilers verbindet, um die Leistung des Verstärkers von Hand einzustellen, oder mit der aus den zu messenden Leitungen bestehenden Teilerbrücke, wobei man so die Anzeige der Entfernung ermöglicht, in der sich der Fehler befindet, und die man direkt an derselben Anzeige, wie bei der Eichung, ablesen kann.

**5.** Anordnung nach Anspruch 4,
**dadurch gekennzeichnet,** daß
die Spannungsquelle (5), der analog-numerische Wandler mit Anzeige (7,73) und der Eingangsverstärker mit variabler Leistung (72) für Gleichstrom vorgesehen sind.

**6.** Anordnung nach Anspruch 4,
**dadurch gekennzeichnet,** daß
die Spannungsquelle (5), der analog-numerische Wandler mit Anzeige (7,73) und der Eingangsverstärker mit variabler Leistung (72) für Wechselstrom mit sehr niedriger Frequenz vorgesehen sind.

**7.** Anordnung nach den Ansprüchen 5 oder 6,
**dadurch gekennzeichnet,** daß
der Eingangsverstärker mit variabler Leistung (71) auch einen zwischen dem Schalter (6) und dem Eingangsverstärker (72) mit variabler Leistung montierten Eingangsverstärker (71) aufweist und daß

8

dieser Eingangsverstärker (71) für sehr hohe Eingangsimpedanz vorgesehen ist.

8. Anordnung nach Anspruch 6,
   **dadurch gekennzeichnet,** daß
   die Wechselstromspannungsquelle ein Spannungsgenerator mit sehr niedriger Frequenz ist.

9. Anordnung nach Anspruch 6,
   **dadurch gekennzeichnet,** daß
   sie eine Kompensationsschaltung für die Streukapazitäten aufweist, mit einem Potentiometer (51) welches dazu dient, einen Teil der Spannung der Spannungsquelle (5) wiederzugewinnen, einem Verstärker (8), der mit zwei die Leistung des Verstärkers (8) bestimmenden Widerständen (52,53) verbunden ist, einem Potentiometer (74) zum Wiedergewinnen eines Teils der Meßspannung und einem, zwischen dem Ausgang des Kompensationsverstärkers und der Klemme (21) der Teilerbrücke eingeschalteten Kondensator (C0), wobei diese Schaltung so eingestellt ist, daß sie den Streukapazitätsstrom ($I_p$) kompensiert.

Fig 1

Fig 2

Fig 3